# FASCICULE DE BREVET EUROPEEN

(11) **EP 2 809 836 B1**
(45) Date de publication et mention de la délivrance du brevet: **10.05.2017**
(21) Numéro de dépôt: 13712346.9
(22) Date de dépôt: 31.01.2013
(51) Int. Cl.: C30B 15/10, C30B 29/06, C30B 28/04, C30B 35/00, C01B 33/021, C04B 41/00, C04B 41/50, C04B 41/87, C09D 1/00, C04B 111/00

(54) **CREUSET POUR LA SOLIDIFICATION DE LINGOT DE SILICIUM ET SON PROCEDE DE FABRICATION**
TIEGEL ZUR VERFESTIGUNG EINES SILICIUMBLOCKS
CRUCIBLE FOR SOLIDIFYING A SILICON INGOT

(30) Priorité: 31.01.2012 FR 1250903
(43) Date de publication de la demande: 10.12.2014
(73) Titulaire: Commissariat à l'Énergie Atomique et aux Énergies Alternatives, 75015 Paris (FR)
(72) Inventeur: HUGUET, Charles, F-92150 Suresnes (FR); BAILLY, Séverine, F-73290 La Motte-Servolex (FR); BRIZE, Virginie, F-38400 Saint Martin d'Hères (FR)
(74) Mandataire: Nony
(86) Numéro de dépôt international: PCT/IB2013/050825
(87) Numéro de publication internationale: WO 2013/114313

(56) Documents cités:
- EP-A1- 0 411 611
- WO-A1-2012/025905
- BILL J ET AL: "Polymer-Derived Ceramic Coatings on C/C-SiC Composites", JOURNAL OF THE EUROPEAN CERAMIC SOCIETY, vol. 16, no. 10, 1 janvier 1996 (1996-01-01), pages 1115-1120, XP004047417, ELSEVIER SCIENCE PUBLISHERS, BARKING, ESSEX, GB ISSN: 0955-2219, DOI: 10.1016/0955-2219(96)00025-8 cité dans la demande
- KROKE E: "Silazane derived ceramics and related materials", MATERIALS SCIENCE AND ENGINEERING R: REPORTS, vol. 26, no. 4-6, 1 avril 2000 (2000-04-01), pages 97-199, XP004198439, ELSEVIER SEQUOIA S.A., LAUSANNE, CH ISSN: 0927-796X, DOI: 10.1016/S0927-796X(00)00008-5

## Description

La présente invention se rapporte à un creuset utile pour la solidification d'un lingot de silicium à partir de silicium à l'état fondu.

Elle concerne également un procédé de préparation d'un tel creuset ainsi que l'utilisation d'un tel creuset pour le traitement du silicium à l'état fondu.

Les creusets selon l'invention sont notamment utilisables dans des procédés de fusion et de solidification de silicium, à des fins par exemple d'obtention de silicium de haute pureté pour des applications dans la génération d'énergie photovoltaïque.

Les cellules photovoltaïques sont, pour l'essentiel, fabriquées à partir de silicium mono- ou poly-cristallin, obtenu à partir de la solidification de silicium liquide dans des creusets. Ce sont les plaquettes découpées dans le lingot formé au sein du creuset qui servent de base à la fabrication des cellules.

Les creusets considérés pour la croissance du lingot sont généralement des creusets en silice, revêtus d'une couche de nitrure de silicium oxydé pour éviter l'adhérence du lingot au creuset après solidification.

Plus précisément, ce comportement anti-adhérent repose pour l'essentiel sur la présence de nitrure de silicium, Si₃N₄, à l'état de poudres oxydées, en surface des parois internes des creusets auxquelles adhère le silicium au cours de son refroidissement. En refroidissant, le lingot de silicium se détache de ces parois par rupture cohésive au sein de la couche de nitrure de silicium, relaxant ainsi les contraintes mécaniques issues de la différence de coefficients d'expansion thermique.

Toutefois, cette technique ne permet pas de prévenir une contamination du silicium par les impuretés présentes dans la poudre de nitrure de silicium [1]. Pour des raisons évidentes, cette contamination, susceptible d'exister au niveau des zones du lingot de silicium formées au contact direct ou avoisinant des parois du creuset, rend le lingot en partie impropre à un usage en applications photovoltaïques.

Il demeure donc à ce jour un besoin pour des creusets de solidification permettant de détacher facilement le lingot de silicium après son refroidissement, tout en limitant la contamination de ce lingot par le revêtement anti-adhérent.

Il demeure également un besoin de tels creusets de solidification qui soient, en outre, réutilisables.

Enfin, dans la perspective d'une production à échelle industrielle, il est souhaitable de proposer un procédé de fabrication de tels creusets par des techniques à bas-coût et ne nécessitant qu'un nombre d'étapes de préparation restreints.

La présente invention vise précisément à proposer de nouveaux creusets utiles pour la solidification d'un lingot de silicium à partir de silicium fondu, satisfaisant à ces attentes.

Les inventeurs ont en effet découvert que les problèmes précités de contamination peuvent être résolus en formant en surface des parois internes d'un creuset conventionnel un revêtement sous forme d'empilement de strates formées à partir de polysilazane(s) et/ou de polysiloxane(s) et de particules inorganiques.

Ainsi, la présente invention concerne, selon un premier de ses aspects un creuset utile pour la solidification d'un lingot de silicium à partir de silicium fondu, caractérisé en ce qu'il est revêtu au moins partiellement sur sa surface interne d'une couche externe se présentant sous la forme d'un empilement de strates, chaque strate possédant une épaisseur variant de 5 à 150 µm, et étant formée d'un matériau obtenu par décomposition thermique de polysilazane(s) et/ou de polysiloxane(s) et dans lequel sont intégrées des particules inorganiques dont la taille varie de 50 nm à 200 µm.

Au sens de l'invention, l'expression « surface interne » entend désigner la surface externe des parois définissant le volume intérieur du creuset. Le « volume intérieur du creuset » désigne, au sens de l'invention, le volume défini par la surface de fond et les parois latérales du corps de base du creuset ou les surfaces externes du corps de base du creuset.

On entend désigner par couche « externe » le fait que la couche formée est en contact direct avec l'atmosphère environnante et/ou le contenant du creuset, c'est-à-dire qu'elle ne possède, elle-même, aucun revêtement sur sa surface opposée aux parois du creuset.

Les polysilazanes sont des polymères organosiliciés dont le squelette principal consiste en un enchaînement d'atomes de silicium et d'azote.

Ces polymères sont déjà proposés à titre de matériaux pro-céramiques au regard de leur aptitude à former par décomposition thermique un matériau céramique composé principalement d'atomes de silicium, de carbone et d'azote.

De tels composés sont notamment déjà mis en oeuvre à des fins de formation en surface de substrats divers tels que par exemple en graphite ou en silice, d'un revêtement doté de propriétés anti-oxydantes et d'étanchéité ([2], [3]).

Le polysilazane contenant des poudres inorganiques a déjà été retenu comme matériau pour renforcer la résistance à l'oxydation de certains substrats carbonés. Toutefois, les procédés proposés pour sa mise en oeuvre consistent en la formation, sur la surface du matériau à traiter, d'une monocouche dérivant de la décomposition thermique par pyrolyse du polysilazane préalablement déposé ([4], [5]).

Quant aux polysiloxanes, ce sont des polymères organosiliciés dont le squelette principal consiste en un enchaînement d'atomes de silicium et d'oxygène.

Ces polymères sont très largement utilisés dans tous les domaines de la microélectronique comme résines photosensibles, comme masques pour la lithographie ou encore comme encapsulants [6]. De nombreux auteurs ont aussi divulgué des techniques d'obtention de matériaux à géométries contrôlées *via* des techniques d'émulsions à partir de polysiloxanes [7].

Toutefois, à la connaissance des inventeurs, il n'a jamais été proposé un revêtement de creusets selon l'invention, formé d'un empilement de strates, chaque strate étant formée d'un matériau obtenu par décomposition thermique de polysilazane(s) et/ou de polysiloxane(s) et dans lequel sont intégrées des particules inorganiques.

Ainsi, la couche externe selon l'invention possède une architecture stratifiée, au regard du fait qu'elle est formée d'au moins deux, voire de plusieurs strates superposées et disposées parallèlement à la surface interne traitée dudit creuset.

A des fins de simplification, une couche conforme à l'invention pourra également être indifféremment désignée dans le texte comme « un empilement de strates », « couche externe » ou « couche de revêtement ».

En particulier, la couche externe selon l'invention peut présenter une épaisseur allant de 10 à 500 µm, de préférence de 50 à 300 µm et plus particulièrement de 100 à 200 µm.

Selon un autre de ses aspects, la présente invention vise à proposer un procédé pour former un revêtement anti-adhérent de haute pureté sur la surface interne d'un creuset utile pour la solidification d'un lingot de silicium à partir de silicium fondu, caractérisé en ce que ledit revêtement est obtenu *via*
▪ (a) la formation d'au moins une strate selon un traitement comprenant :
   (1) au moins une fois l'enchaînement des étapes :
      (i) mise en contact de la surface interne dudit creuset, avec une solution comprenant au moins un polysilazane et/ou un polysiloxane, et contenant en outre un matériau particulaire dont les particules possèdent une taille variant de 50 nm à 200 µm, dans des proportions materiau particulaire/polysilazane et/ou polysiloxane allant de 10 à 70 % en volume, de préférence de 40 à 50 % en volume ;
      (ii) condensation-réticulation de ladite solution par traitement thermique ; et
      (iii) éventuellement une pré-pyrolyse sous air à une température allant de 270 à 700°C ;
   (2) une pyrolyse sous atmosphère et température contrôlées à une température supérieure à 700°C pendant au moins 1 heure et, éventuellement ; (3) un recuit d'oxydation ; suivie de
▪ (b) la superposition d'une ou plusieurs strates consécutives sur la strate formée en étape (a), chaque strate étant formée par répétition au moins une fois de l'enchaînement des étapes (i), (ii) et éventuellement (iii), suivie de l'étape (2) et éventuellement de l'étape (3).

Selon une variante préférée, l'enchaînement des étapes considéré en (1) comprend obligatoirement une étape de pré-pyrolyse.

La formation d'une couche externe selon l'invention s'avère particulièrement avantageuse à plusieurs titres.

Tout d'abord, une telle couche sous la forme d'un empilement de strates présente avantageusement des propriétés anti-adhérentes à l'égard du silicium solide et permet de garantir un niveau de pureté accru au lingot de silicium correspondant.

Comme démontré dans les exemples qui suivent, les creusets selon l'invention permettent un détachement aisé des lingots de silicium solidifiés, et ce en amoindrissant significativement leur pollution par le revêtement anti-adhésif. Un lingot de silicium formé au contact de cet empilement s'en détache pour l'essentiel, par rupture cohésive à l'intérieur dudit empilement. Les creusets selon l'invention peuvent ainsi être réutilisés un grand nombre de fois sans altérer leurs propriétés et s'avèrent, à ce titre, particulièrement avantageux au niveau industriel.

Les propriétés anti-adhésives des creusets selon l'invention sont notamment obtenues *via* la présence de la couche poreuse oxydée dont la cinétique de désoxydation est suffisamment lente pour éviter l'infiltration du silicium liquide dans la couche jusqu'au contact avec le substrat, et donc permettre son détachement du substrat.

Par ailleurs, les inventeurs ont constaté, de manière avantageuse, que l'ajout du matériau particulaire dont les particules présentent une taille allant de 50 nm à 200 µm à la solution de polysilazane(s) et/ou polysiloxane(s) permet, en limitant le retrait intrinsèque du matériau de la couche lors de son traitement thermique selon l'invention, d'accéder à des strates épaisses, plus particulièrement d'épaisseur variant de 5 à 150 µm.

Il est ainsi possible d'obtenir selon l'invention une couche présentant une épaisseur satisfaisante en formant un nombre limité de strates conformes à l'invention. En particulier, l'empilement de strates conforme à l'invention peut comprendre de 2 à 8 strates, lesdites strates étant superposées et contigües. Au sens de l'invention, le terme « contigu » signifie que les strates en question sont accolées et attenantes. L'épaisseur importante des strates formées selon l'invention permet ainsi une réduction du nombre d'étapes nécessaires à l'élaboration du revêtement pour les creusets, ce qui est particulièrement déterminant au niveau de la mise en oeuvre du procédé de préparation des creusets à l'échelle industrielle.

Egalement, le procédé de l'invention met en oeuvre le dépôt du revêtement anti-adhérant sous forme liquide, selon des techniques classiques et peu coûteuses, et permettant d'atteindre un très bon état de surface.

D'autres caractéristiques, avantages et modes d'application du creuset et du procédé selon l'invention ressortiront mieux à la lecture de la description qui va suivre, donnée à titre illustratif et non limitatif.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, l'expression « comportant/comprenant un(e) » doit être comprise comme « comportant/comprenant au moins un(e) ».

### REVETEMENT

Comme indiqué précédemment, les creusets selon l'invention sont revêtus au moins partiellement sur leur surface interne d'une couche externe formée d'un empilement de strates, chacune des strates étant formée d'un matériau obtenu par décomposition thermique de polysilazane(s) et/ou de polysiloxane(s) dans lequel sont intégrées des particules inorganiques.

Selon une première variante de réalisation de l'invention, le matériau formant une strate conforme à l'invention dérive de la décomposition thermique de polysilazane(s).

Les polysilazanes convenant à l'invention peuvent être représentés par la formule suivante -(SiR'R"-NR"')ₙ-(SiR*R**-NR***)ₚ-, dans laquelle R', R", R"', R*, R** et R*** repésentent indépendamment les uns des autres un atome d'hydrogène ou un radical alkyle, aryle, vinyle ou (trialkoxysilyl)alkyle substitué ou non-substitué, n et p ayant des valeurs telles que le polysilazane présente un poids moléculaire moyen allant de 150 à 150 000 g/mol.

De tels polysilazanes sont notamment décrits dans le document US 2009/0286086.

Selon une autre variante de réalisation de l'invention, le matériau formant une strate conforme à l'invention dérive de la décomposition thermique de polysiloxane(s).

Les polysiloxanes convenant à l'invention peuvent être représentés par la formule suivante (SiR₁R₂-O)ₖ-(SiR₃R₄-O)ₘ dans laquelle R₁, R₂, R₃ et R₄ représentent indépendamment les uns des autres H, CH₃, C₂H₅, C₆H₅, CH₂=CH-, etc., k et m sont compris entre 1 et 1000.

De tels polysiloxanes sont par exemple décrits dans le document CA 1296468.

Le matériau obtenu par décomposition thermique de polysilazane(s) et/ou de polysiloxane(s) est à base de Si et d'un ou plusieurs éléments choisis parmi C, N et O.

Plus particulièrement, le matériau obtenu par décomposition thermique de polysilazane(s) et/ou de polysiloxane(s) peut être à base de carbure de silicium (SiC), de nitrure de silicium (Si₃N₄), de silice (SiO₂), d'oxycarbonitrure de silicium et/ou d'oxycarbure de silicium (SiOC).

Par oxycarbonitrure de silicium, on entend désigner les composés de formule générale SiₓO_{y}N_{z}C_{w}, tels que par exemple ceux décrits dans le document US 5,438,025, comme par exemple SiNCO₂ ou Si N_{0,52} O_{1,45} C_{0,32}.

Le matériau formant chaque strate conforme à l'invention dérive plus particulièrement d'un traitement thermique de type pyrolyse, de polysilazane(s) et/ou polysiloxane(s), comme développé plus particulièrement par la suite.

### Particules inorganiques

Comme indiqué précédemment, le matériau formant les strates de la couche de revêtement du creuset selon l'invention comprend des particules inorganiques dont la taille varie de 50 nm à 200 µm.

De préférence, les dimensions desdites particules inorganiques varient de 500 nm à 50 µm, de préférence de 0,8 µm à 10 µm.

Les particules inorganiques peuvent être plus particulièrement choisies parmi des particules de silicium (Si) éventuellement oxydées en surface, de nitrure de bore (BN), de nitrure de silicium (Si₃N₄), de carbure de silicium (SiC), d'oxycarbure de silicium (SiOC), de silice (SiO₂), d'oxycarbonitrure de silicium (SiNCO), de carbonitrure de silicium et de bore (SiBCN), et leurs mélanges.

Selon un mode de réalisation particulièrement préféré, lesdites particules inorganiques sont de même nature chimique que le matériau formant la strate ou les strates les contenant.

Selon un mode de réalisation particulier, lesdites particules inorganiques sont formées d'oxycarbure de silicium (SiOC).

Selon un autre mode de réalisation particulier, il s'agit de particules formées majoritairement de silice (SiO₂). Par « majoritairement », on entend signifier que les particules sont formées d'au moins 90 % en poids de silice, de préférence d'au moins 95 % en poids de silice.

Selon encore un autre mode de réalisation particulier, il peut s'agir de particules de silicium éventuellement oxydées en surface.

Les particules inorganiques mises en oeuvre dans le procédé de préparation du revêtement selon l'invention, comme décrit plus particulièrement par la suite, peuvent se présenter sous la forme d'une poudre.

Selon une variante de réalisation, il peut s'agir de poudres disponibles commercialement. A titre d'exemple de telles poudres, on peut citer :
- le nitrure de silicium (Si₃N₄) commercialisé sous la référence SNE10^{®} par la société UBE,
- le silicium commercialisé sous la forme de poudre de silicium cristallin/amorphe sous la référence 38715 par la société Alfa Aesar, et
- le carbure de silicium (SiC) commercialisé sous la forme de poudre de α-SiC sous la référence UF15SiC par la société H.C. Starck.

Selon une autre variante de réalisation, les particules inorganiques peuvent être préparées préalablement à la formation du revêtement selon l'invention. L'homme du métier est à même de mettre en oeuvre les méthodes adaptées à la préparation des nanoparticules convenant à l'invention.

De manière avantageuse, les particules inorganiques selon l'invention peuvent être formées à partir de polysilazane(s) et/ou de polysiloxane(s).

De manière surprenante, les inventeurs ont découvert que la mise en oeuvre de telles particules formées à partir de polysilazane(s) et/ou de polysiloxane(s) au sein de la solution de polysilazane(s) et/ou de polysiloxane(s) pour former une strate selon l'invention, permettait d'atteindre des puretés améliorées de la couche de matériau déposée. La mise en oeuvre au sein d'une phase liquide de particules issues du même matériau, comme décrit plus particulièrement par la suite pour le procédé de l'invention, pour accéder à une couche de revêtement n'était nullement évidente. En effet, on pouvait s'attendre à ce que l'incorporation de particules à base d'un matériau présentant intrinsèquement un retrait identique à celui du matériau de revêtement conduise à une fissuration trop importante de la couche lors de son traitement thermique.

Dans ce cas, une poudre de particules convenant à l'invention peut par exemple être formée *via* un procédé d'émulsion à base de polysilazane(s) et/ou de polysiloxane(s), tel que décrit par Vakifahmetoglu *et al.* [7].

Les particules convenant à l'invention peuvent encore être formées *via* un procédé de broyage de polysilazane et/ou polysiloxane pyrolysé massif, avec un broyeur planétaire dont les éléments sont en agate ultra pure ou en Si₃N₄. A titre de broyeur planétaire, on peut notamment citer celui commercialisé sous la référence PM100 par la société Retsch.

De manière avantageuse, le contrôle de la quantité des particules incorporées, obtenues par exemple, *via* un procédé d'émulsion mixte ou *via* un broyage (microfissuration) permet d'envisager un contrôle de la porosité du revêtement, et donc des propriétés mécaniques de la couche adhérente, et de la physique de détachement du lingot. En effet, autour des particules se développent des microfissures non traversantes, qui augmentent la porosité non débouchante du matériau, favorable au mécanisme de détachement lors du refroidissement.

### Empilement des strates

Comme indiqué précédemment, la couche externe formant le revêtement du creuset selon l'invention est formée d'un empilement de strates.

De préférence, la couche externe comprend de 2 à 8 strates, en particulier de 4 à 6 strates.

La couche externe peut présenter une épaisseur allant de 10 à 500 µm, en particulier de 50 à 300 µm, de préférence de 100 à 200 µm.

Chacune des strates constituant la couche est formée d'un matériau obtenu par décomposition thermique de polysilazane(s) et/ou de polysiloxane(s), en particulier tel que décrit précédemment, et dans lequel sont intégrées des particules inorganiques, de préférence telle que décrites précédemment.

Chacune des strates possède plus particulièrement une épaisseur variant de 5 à 150 µm, de préférence de 10 µm à 50 µm.

L'épaisseur des strates et de la couche externe peut être déterminée de façon conventionnelle par microscopie électronique à balayage (MEB).

Comme développé par la suite, le matériau formant chaque strate conforme à l'invention dérive d'un traitement thermique de type pyrolyse, de polysilazane(s) et/ou polysiloxane(s).

*Via* l'ajustement des conditions de pyrolyse, en terme de palier de température, de vitesse et de maintien en température et/ou de nature de l'atmosphère considérée lors de la pyrolyse, par exemple argon ou azote, il s'avère possible d'une part d'accéder à des matériaux de composition particulière pour une strate donnée et donc de réaliser un empilement de strates de nature chimique identique ou non et, d'autre part, de moduler l'organisation structurelle de chacune des strates.

Selon une première variante de réalisation, l'ensemble des strates constituant la couche de revêtement peuvent être formées d'un même matériau.

Selon un autre mode de réalisation, au moins deux strates de ladite couche peuvent être formées de matériaux différents. Dans ce second mode de réalisation, deux strates constituées des mêmes matériaux peuvent avoir des compositions différentes, au regard par exemple de conditions différentes retenues pour former chacune des strates correspondantes.

Selon un mode de réalisation particulier, une ou plusieurs des strates, voire l'ensemble des strates constituant la couche de revêtement selon l'invention est/sont formée(s) d'un matériau obtenu par décomposition thermique de polysilazane(s), dans lequel sont intégrées des particules inorganiques, notamment choisies parmi des particules d'oxycarbure de silicium, de silice, de nitrure de silicium ou d'oxycarbonitrure de silicium.

Le matériau dérivant de la décomposition thermique de polysilazane(s) et/ou de polysiloxane(s) de la strate peut être, au moins en partie, sous forme amorphe.

Par « amorphe », au sens cristallographique, on entend un matériau dans lequel les atomes ne respectent aucun ordre à moyenne et grande distance, ce qui le distingue des matériaux cristallisés. La caractérisation s'effectue par analyse aux rayons X (DRX).

Les caractéristiques morphologiques des strates obtenues selon l'invention dépenderont bien entendu des conditions de leur formation, et en particulier de la nature de la solution de dépôt ainsi que des paramètres retenus pour le traitement thermique et en particulier de la température.

De manière générale, les strates formées selon l'invention se présentent sous la forme de tuiles non jointives.

Ainsi, selon un mode de réalisation particulier, une ou plusieurs des strates, voire l'ensemble des strates formant la couche externe se présentent sous la forme de tuiles non jointives.

L'espacement latéral des tuiles peut être compris entre 0,1 µm et 50 µm, plus précisément entre 0,1 µm et 20 µm, en particulier de 0,5 à 10 µm, et de préférence de 0,5 à 5 µm.

La dimension latérale des tuiles peut être comprise entre 10 µm et 800 µm, par exemple entre 100 µm et 500 µm. La dimension latérale des tuiles ainsi que l'espacement latéral entre deux tuiles peuvent être déterminés de façon conventionnelle par microscopie électronique à balayage (MEB).

Une tuile est caractérisée par une dimension d'épaisseur inférieure à sa dimension latérale (longueur, largeur, diamètre).

Selon l'invention, le rapport dimension latérale/épaisseur des tuiles peut être compris entre 1,2 et 200.

Du fait de la mise en oeuvre d'un matériau particulaire, la couche de revêtement selon l'invention possède, de manière générale, un aspect de surface inhomogène.

La couche se présentant sous la forme d'un empilement de tuiles non jointives conforme à l'invention est également caractérisée par sa résistance au cisaillement, qui doit être supérieure à 1 Pa et inférieure ou égale à 500 MPa.

Au sens de l'invention, la « résistance au cisaillement » d'une couche entend désigner la résistance mécanique à une contrainte développée dans le plan de la couche.

Elle s'oppose à une résistance à une traction qui serait en revanche la résistance à une contrainte développée perpendiculairement au plan de la couche d'empilement.

Ce paramètre de résistance au cisaillement peut être déterminé par toute technique conventionnelle connue de l'homme du métier, et notamment par la mesure définie dans la norme ASTM D1002, par exemple grâce à la machine eXpert 2611 du fabricant ADMET.

La couche conforme à l'invention ne doit pas être sujette à un phénomène de désagrégation ni d'effritement lors de simples manipulations du creuset. De même, elle ne doit pas être altérée par les contraintes induites lors de la fusion de la charge de silicium, notamment celles induites par la convection naturelle.

Ainsi, la couche conforme à l'invention présente une résistance au cisaillement supérieure à 1 Pa, par exemple supérieure à 10 kPa, notamment supérieure à 50 kPa.

Par ailleurs, la couche conforme à l'invention doit également présenter une résistance au cisaillement inférieure à la contrainte induite par la différence de dilatation thermique entre le silicium en cours de solidification et le substrat du creuset.

De préférence, la couche conforme à l'invention présente une résistance au cisaillement inférieure à la contrainte critique en cisaillement du silicium, c'est-à-dire inférieure à la contrainte minimale qui favorise l'apparition des dislocations du silicium lorsque celui-ci est dans son domaine de plasticité.

Cela permet en effet de faciliter notamment le détachement du lingot de silicium au cours de son refroidissement au sein du creuset, et de limiter également l'apparition de défauts, en particulier de dislocations.

En particulier, la couche conforme à l'invention peut présenter une résistance au cisaillement inférieure ou égale à 300 MPa, par exemple inférieure ou égale à 200 MPa, par exemple inférieure ou égale à 100 MPa, par exemple inférieure ou égale à 5 MPa.

### PROCEDE

Selon un autre de ses aspects, la présente invention vise à proposer un procédé pour former un revêtement anti-adhérent de haute pureté sur la surface interne d'un creuset utile pour la solidification d'un lingot de silicium à partir de silicium fondu, caractérisé en ce que ledit revêtement est obtenu *via*
▪ (a) la formation d'au moins une strate selon un traitement comprenant :
   (1) au moins une fois l'enchaînement des étapes :
      (i) mise en contact de la surface interne dudit creuset, avec une solution comprenant au moins un polysilazane et/ou un polysiloxane, et contenant en outre un matériau particulaire dont les particules possèdent une taille variant de 50 nm à 200 µm, dans des proportions materiau particulaire/polysilazane et/ou polysiloxane allant de 10 à 70 % en volume, de préférence de 40 à 50 % en volume ;
      (ii) condensation-réticulation de ladite solution par traitement thermique ; et
      (iii) éventuellement une pré-pyrolyse sous air à une température allant de 270 à 700°C ;
   (2) une pyrolyse sous atmosphère et température contrôlées à une température supérieure à 700°C pendant au moins 1 heure et, éventuellement ;
   (3) un recuit d'oxydation ; suivie de
▪ (b) la superposition d'une ou plusieurs strates consécutives sur la strate formée en étape (a), chaque strate étant formée par répétition au moins une fois de l'enchaînement des étapes (i), (ii) et éventuellement (iii), suivie de l'étape (2) et éventuellement de l'étape (3).

La mise en contact de la solution de polysilazane(s) et/ou de polysiloxane(s) avec la surface interne dudit creuset en étape (i) peut être effectuée par toute technique conventionnelle connue de l'homme du métier. Par exemple, elle peut être déposée par trempage, par tournage, par pistolétage ou encore à l'aide d'un pinceau.

De préférence, elle est effectuée par pulvérisation de la solution sur la surface interne du creuset.

L'utilisation d'une phase liquide permet de réaliser un dépôt présentant un très bon état de surface.

Selon un mode de réalisation, la solution de l'étape (i) peut comprendre également un solvant, par exemple un solvant anhydre aprotique, et, le cas échéant, un initiateur de polymérisation, par exemple de type peroxyde organique.

A titre de solvant anhydre aprotique, on peut notamment citer le toluène, le diméthylformamide, le diméthylsulfoxyde et le dibutyléther.

A titre d'initiateur de polymérisation, on peut notamment citer le peroxyde de dicumyle, le diperoxyester, le peroxycarbonate ou l'acétylacétate de zirconium.

Les caractéristiques morphologiques des strates obtenues selon l'invention dépendent notamment de la viscosité de la solution de polysilazane et/ou de polysiloxane déposée, et par conséquent notamment de la concentration en polysilazane et/ou polysiloxane dans cette solution.

De préférence, la solution de polysilazane et/ou polysiloxane utilisée selon l'invention comprend de 10 à 90 % en poids de polysilazane(s) et/ou de polysiloxane(s) par rapport au poids total de ladite solution, en particulier de 20 à 80 % en poids, et plus particulièrement de 40 à 60 % en poids.

Selon un mode de réalisation particulier de l'invention la formation d'au moins une desdites strates selon les procédés décrits précédemment comprend l'étape (iii) de pré-pyrolyse.

De préférence la formation de chacune des strates dudit revêtemement anti-adhérent comprend l'étape (iii) de pré-pyrolyse.

Avantageusement, l'étape (iii) de pré-pyrolyse est réalisée à une température allant de 400 à 600°C.

L'étape (iii) de pré-pyrolyse peut être réalisée pendant une durée allant de 5 minutes à 1 heure, de préférence de 15 à 30 minutes.

Selon un sous mode de ce mode de réalisation, la formation d'au moins une strate impliquant la mise en oeuvre des étapes (i), (ii) et (iii), comprend préalablement à la mise en oeuvre de l'étape (2), la répétition au moins une fois, des étapes (i), (ii) et (iii).

Ce sous mode de réalisation permet avantageusement de réduire le temps ainsi que le coût énergétique nécessaire à la formation d'une strate d'une épaisseur donnée.

De préférence, lorsque la formation de l'ensemble des strates du revêtement implique la mise en oeuvre des étapes (i), (ii) et (iii), la formation de chacune desdites strates comprend préalablement à la mise en oeuvre de l'étape (iv), la répétition au moins une fois, des étapes (i), (ii) et (iii).

Chaque répétition des étapes (i), (ii) et (iii) constitue la formation d'une sous-strate. Une strate peut ainsi comprendre un certain nombre de sous-strates en fonction du nombre de répétitions des étapes (i) à (iii).

Une strate peut comprendre de 2 à 8 sous-strates, de préférence de 3 à 6 sous-strates, en particulier 4 sous-strates.

Les conditions de mise en oeuvre de chacune des étapes (i) à (iii) peuvent être identiques ou différentes pour la formation de chaque sous strate d'une même strate.

Ainsi deux sous-strates d'une même strate peuvent être formées de matériaux distincts ou identiques.

De préférence, chaque sous-strate d'une même strate est obtenue par reproduction des étapes (i) à (iii) avec les mêmes conditions de mise en oeuvre. Dans ce cas, chaque sous-strate est formée de matériaux identiques.

Lorsque les strates sont formées de sous-strates, la couche externe selon l'invention peut comprendre de 2 à 8 strates, de préférence de 2 à 4 strates, en particulier, 2 strates.

L'étape (2) de pyrolyse est réalisée sous atmosphère contrôlée, par exemple sous une atmosphère constituée d'argon, d'azote ou d'air, de préférence d'argon.

Selon un mode de réalisation, l'étape de pyrolyse (2) de l'une des étapes (a) et (b) est réalisée sous atmosphère réactive à l'égard du matériau dérivant du polysilazane et/ou du polysiloxane, par exemple sous azote ou sous air, l'autre étape étant réalisée sous atmosphère inerte, par exemple sous argon.

Typiquement, ce traitement comporte au moins un palier d'au moins 1 heure à au moins 1000°C, éventuellement précédé d'un recuit à basse température, par exemple d'une à deux heures, entre 100°C et 200°C.

Il est entendu que ce recuit à basse température correspond à l'étape (ii) de condensation-réticulation du procédé selon l'invention.

Une étape additionnelle de recuit d'oxydation sous air peut être également réalisée.

Cette étape de recuit présente un intérêt tout particulier lorsque la solution utilisée est une solution de polysilazane(s) et que l'étape de pyrolyse est réalisée sous une atmosphère constituée d'argon, d'azote ou d'ammoniaque. Le matériau obtenu est en effet alors soit du SiC, soit du Si₃N₄, soit un matériau de composition intermédiaire de type oxycarbonitrure. Il peut être avantageux d'oxyder ce matériau pour lui conférer sa propriété non mouillante vis-à-vis du silicium liquide.

Lorsque l'étape de pyrolyse est réalisée sous une atmosphère constituée d'air, l'étape de recuit possède un intérêt moindre puisque le matériau obtenu est déjà oxydé à l'issue de la pyrolyse.

L'invention peut être avantageusement réalisée sur tout type de creuset conventionnel, et par exemple sur des creusets constitués d'un substrat céramique dense, par exemple en carbure de silicium (SiC), en nitrure de silicium (Si₃N₄) ou en silice (SiO₂), ou d'un substrat poreux, par exemple en graphite, éventuellement recouvert d'une couche imperméabilisante (en carbure de silicium par exemple).

De préférence, on choisira un substrat en graphite, et notamment en graphite isostatique, pyrolytique, vitreux, fibreux, composite carbone-carbone ou flexible qui présente avantageusement une bonne résistance à la température.

Selon un mode de réalisation, en particulier dans le cas de la mise en oeuvre d'un creuset constitué d'un substrat poreux, en particulier en graphite, le creuset peut comprendre en outre au moins partiellement sur sa surface interne une couche isolante intermédiaire.

Cette couche isolante intermédiaire est alors localisée entre la surface interne du creuset et la couche externe de revêtement conforme à l'invention.

Une telle couche isolante intermédiaire est destinée à isoler ledit substrat de la couche du revêtement.

Comme il ressort de ce qui suit, cette couche est généralement formée, au moins partiellement, en surface interne dudit creuset préalablement à la formation de la couche externe selon l'invention.

Cette couche isolante intermédiaire apposée en surface du matériau formant ledit creuset pourra notamment être une couche dense et continue de céramique apte à assurer un comportement barrière, voire antioxydant.

De telles couches isolantes sont bien connues de l'homme du métier.

Selon un mode de réalisation, cette couche isolante intermédiaire peut être formée d'au moins deux matériaux distincts, constituant alternativement cette couche isolante.

En particulier, le premier type de l'un des matériaux peut être formé majoritairement, voire uniquement, de silice (SiO₂), et l'autre matériau peut être formé majoritairement, voire uniquement, de carbure de silicium (SiC).

Selon une variante de réalisation, le procédé de l'invention peut ainsi comprendre, dans le cadre de la mise en oeuvre d'un creuset constitué d'un substrat poreux, en particulier en graphite, préalablement aux étapes (a) et (b) précitées, une étape de formation d'une couche isolante intermédiaire sur la surface interne dudit creuset telle que décrite précédemment.

Le procédé selon l'invention permet de limiter, voire d'éviter, la contamination du lingot de silicium, et d'obtenir ainsi des lingots de silicium de plus grande pureté par rapport à ceux obtenus jusqu'à ce jour, et ce tout en mettant en oeuvre des techniques de dépôts conventionnelles et peu coûteuses.

Ainsi, la pureté moyenne des revêtements à base de polysilazane(s) et/ou polysiloxane(s) selon l'invention est supérieure à 99,99 % en poids, en particulier supérieure à 99,996 % en poids, soit bien supérieure à celle des revêtements conventionnels obtenus à partir de poudres, par exemple de poudres de Si₃N₄ qui présentent des puretés inférieures à 99,96 %, voire de l'ordre de 98 %.

L'invention va maintenant être décrite au moyen des exemples suivants donnés bien entendu à titre illustratif et non limitatif de l'invention.

### EXEMPLES

### EXEMPLE 1

Le creuset utilisé est un creuset en silice frittée (Zyarock™) de la société Vésuvius, de diamètre interne 150 mm et de hauteur interne 150 mm.

### Préparation du matériau particulaire

Le matériau particulaire est obtenu à partir d'un procédé d'émulsion par goutte à goutte selon le protocole suivant. Un mélange de 5 g de polysiloxane et de 7 mL de toluène, contenant 0,16 g d'acétylacétate de zirconium en tant que catalyseur de polymérisation en phase liquide est additionné goutte à goutte dans 80 mL d'eau contenant du polyéthylène glycol sorbitan monooléate (Tween 80) et un surfactant, sous agitation (pendant 15 minutes).

La polymérisation du polysiloxane a lieu en phase liquide sous forte agitation.

Après séchage de la suspension ainsi obtenue (pendant 12 h sur plaque chauffante à 140°C), une étape de pyrolyse à 1200 °C pendant 4 heures sous atmosphère d'azote a lieu afin de fixer la structure du matériau.

Un matériau de composition SiOC amorphe sous forme de microbilles de taille inférieure à la dizaine de microns est alors obtenu. Le traitement à température limitée a permis de ne pas initier le processus de frittage des poudres. Ainsi, lors du mélange de la poudre compacte en solution, une simple agitation magnétique permet de recréer une suspension de particules homogène.

### Formation du revêtement du creuset

Une couche multi-strates selon l'invention ou encore un empilement de tuiles non jointives selon l'invention a été formé sur ce creuset, selon le protocole suivant.

La poudre précédemment formée est dispersée dans une solution (dans un rapport volumique poudre/solution de 50/50) contenant 80 % en poids de polysilazane (Ceraset PSZ20™ de la société CLARIANT) dans du dibutyléther sous agitation vigoureuse.

La suspension obtenue est ensuite projetée par pulvérisation sur la surface interne du creuset, puis une pyrolyse sous air pendant 2 heures à 1000 °C est réalisée, précédée d'un recuit à basse température (150 °C pendant 2 heures).

Cette succession d'étapes (pulvérisation/recuit à basse température/pyrolyse) est répétée 4 fois afin d'obtenir la couche finale. La couche déposée présente une épaisseur d'environ 100 µm estimée par microscopie optique.

### Formation d'un lingot de silicium dans le creuset disposant du revêtement

Le creuset selon l'invention ainsi formé est testé comme suit :
800 g de silicium de qualité électronique sont déposés manuellement et très délicatement dans le creuset résultant. Le silicium est ensuite fondu en suivant le cycle suivant : montée en température à une vitesse de 200 °C par heure jusqu'à 1000 °C sous vide primaire, suivi d'un palier d'une durée d'une heure avec introduction d'une atmosphère d'argon circulant (débit 0,7 l/min), puis montée en température à une vitesse de 150 °C par heure jusqu'à 1500 °C et maintien à cette température pendant 6 heures, et enfin descente à une vitesse de 50 °C par heure jusqu'à 1200 °C. Le refroidissement s'effectue ensuite librement jusqu'à température ambiante.

Après refroidissement complet, le lingot de silicium ainsi formé se détache du creuset conforme à l'invention sans efforts et sans présenter aucune fissure.

### EXEMPLE 2

Le creuset utilisé est le même que dans l'exemple précédent.

### Préparation du matériau particulaire

Le matériau particulaire est obtenu à partir de poudre de silicium micronique (référence 38715 de la société Alfa Aesar), de taille (indiquée par le fournisseur) inférieure à 5 µm. La poudre est oxydée sous air zéro (Air Product) dans un four résistif en silice, à 1000°C pendant 30 minutes. L'épaisseur d'oxyde en surface des grains est estimée par microscopie électronique en transmission (MET) à une centaine de nanomètres.

### Formation du revêtement du creuset

Une couche multi-strates selon l'invention ou encore un empilement de tuiles non jointives selon l'invention a été formé sur ce creuset, selon le protocole suivant.

La poudre précédemment formée est dispersée dans une solution (dans un rapport volumique poudre/solution de 50/50) contenant 80 % en poids de polysilazane (Ceraset PSZ20™ de la société CLARIANT) dans du dibutyléther sous agitation vigoureuse.

La suspension obtenue est ensuite projetée par pulvérisation sur la surface interne du creuset, puis une pyrolyse sous air pendant 2 heures à 1000°C est réalisée, précédée d'un recuit à basse température (150°C pendant 2 heures).

Cette succession d'étapes (pulvérisation/recuit à basse température/pyrolyse) est répétée 4 fois afin d'obtenir la couche finale. La couche déposée présente une épaisseur d'environ 125 µm estimée par microscopie optique.

### Formation d'un lingot de silicium dans le creuset disposant du revêtement

Le creuset selon l'invention ainsi formé est testé comme suit :
800 g de silicium solide de qualité électronique sont ensuite placés manuellement et très délicatement dans le creuset résultant, puis fondus selon le cycle suivant : montée en température à une vitesse de 250 °C par heure jusqu'à 800 °C sous vide primaire, suivi d'un palier d'une durée d'une heure avec introduction d'une atmosphère d'argon statique, puis montée en température à une vitesse de 150 °C par heure jusqu'à 1500 °C et maintien à cette température pendant 6 heures, et enfin descente à une vitesse de 50 °C par heure jusqu'à 1200 °C. Le refroidissement s'effectue ensuite librement jusqu'à température ambiante.

Après refroidissement complet, le lingot de silicium ainsi formé se détache du creuset conforme à l'invention sans efforts et sans présenter aucune fissure.

### EXEMPLE 3

Le creuset est le même que précédemment.

### Préparation du matériau particulaire

Le matériau particulaire est obtenu à partir du broyage d'un massif de polysilazanes (Ceraset PSZ20™ de la société CLARIANT) polymérisés sous argon à 200°C pendant 2 heures puis pyrolysés sous argon pendant une heure à 1000°C, par un broyeur planétaire (PM100 de la société Retsch) dont les éléments sont en agate ultra pure.

La poudre obtenue est constituée de grains amorphes de composition SiNCO. La technique MEB (microscope électronique à balayage) a mis en évidence que moins d'un quart de la population totale présente des dimensions supérieures à 10 µm.

### Formation du revêtement du creuset

Une couche multi-strates selon l'invention ou encore un empilement de tuiles non jointives selon l'invention a été formé sur ce creuset, selon le protocole suivant.

La poudre précédemment formée est dispersée dans une solution (dans un rapport volumique poudre/solution de 50/50) contenant 50 % en poids de polysilazane (Ceraset PSZ20™ de la société CLARIANT) dans du dibutyléther sous agitation vigoureuse. La suspension obtenue est ensuite projetée par pulvérisation sur la surface interne du creuset, puis une pyrolyse sous air pendant 2 heures à 1000°C est réalisée, précédée d'un recuit à basse température (150°C pendant 2 heures).

Cette succession d'étapes (pulvérisation/recuit à basse température/pyrolyse) est répétée 2 fois afin d'obtenir la couche finale. La couche déposée présente une épaisseur d'environ 65 µm estimée par microscopie optique.

### Formation d'un lingot de silicium dans le creuset disposant du revêtement

Le creuset selon l'invention ainsi formé est testé comme suit :
800 g de silicium solide de qualité électronique sont ensuite placés manuellement et très délicatement dans le creuset résultant, puis fondus selon le cycle suivant : montée en température à une vitesse de 200 °C par heure jusqu'à 1000 °C sous vide primaire, suivi d'un palier d'une durée d'une heure avec introduction d'une atmosphère d'argon circulant (débit 0,7 l/min), puis montée en température à une vitesse de 100 °C par heure jusqu'à 1470 °C et maintien à cette température pendant 5 heures, et enfin descente à une vitesse de 100 °C par heure jusqu'à 1000 °C. Le refroidissement s'effectue ensuite librement jusqu'à température ambiante.

Après refroidissement complet, le lingot de silicium ainsi formé se détache du creuset conforme à l'invention sans efforts et sans présenter aucune fissure.

### EXEMPLE 4

Le creuset utilisé est un creuset en graphite grade 2320PT revêtu SiC (épaisseur 100 à 150 µm) fabriqué par la société Mersen, de même dimensions que précédemment.

### Préparation du matériau particulaire

Le matériau particulaire mis en oeuvre est la poudre de Si₃N₄ commercialisée sous la référence SNE10^{®} par la société UBE.

### Formation du revêtement du creuset

Une couche multi-strates selon l'invention ou encore un empilement de tuiles non jointives selon l'invention a été formé sur ce creuset, selon le protocole suivant.

La poudre citée précédemment est dispersée dans une solution (dans un rapport volumique poudre/solution de 50/50) contenant 50 % en poids de polysilazane (Ceraset PSZ20™ de la société CLARIANT) dans du dibutyléther sous agitation vigoureuse. La suspension obtenue est ensuite projetée par pulvérisation sur la surface interne du creuset, puis une pyrolyse sous air pendant 2 heures à 1000°C est réalisée, précédée d'un recuit à basse température (150°C pendant 2 heures).

Cette succession d'étapes (pulvérisation/recuit à basse température/pyrolyse) est répétée 2 fois afin d'obtenir la couche finale. La couche déposée présente une épaisseur d'environ 125 µm estimée par microscopie optique.

### Formation d'un lingot de silicium dans le creuset disposant du revêtement

Le creuset selon l'invention ainsi formé est testé comme suit :
800 g de silicium solide de qualité électronique sont ensuite placés manuellement et très délicatement dans le creuset résultant, puis fondus selon le cycle suivant : montée en température à une vitesse de 250 °C par heure jusqu'à 800 °C sous vide primaire, suivi d'un palier d'une durée d'une heure avec introduction d'une atmosphère d'argon statique, puis montée en température à une vitesse de 150 °C par heure jusqu'à 1500 °C et maintien à cette température pendant 6 heures, et enfin descente à une vitesse de 50 °C par heure jusqu'à 1200 °C. Le refroidissement s'effectue ensuite librement jusqu'à température ambiante.

Après refroidissement complet, le lingot de silicium ainsi formé se détache du creuset conforme à l'invention sans efforts et sans présenter aucune fissure.

### EXEMPLE 5

### Analyse de la pureté des lingots obtenus

A titre comparatif, un lingot témoin est moulé dans un creuset en silice fritté revêtu d'un revêtement standard à base de Si₃N₄.

Les lingots obtenus en exemples 1 à 4 et le lingot témoin sont découpés en tranches verticales de 20 mm d'épaisseur et des analyses de durée de vie des porteurs minoritaires dans ces tranches sont réalisées.

Le principe de cette mesure est le suivant : une excitation laser pulsée de la surface (jusqu'à 1 mm de profondeur) permet de générer des paires électron-trou dans le matériau semi-conducteur qui vont se recombiner après un temps caractéristique (durée de vie) qui est fortement dépendant de la quantité d'impuretés présentes, issues des matériaux du creuset. La cartographie des durées de vie dans les tranches des lingots est réalisée par une mesure de la décroissance de photoconductivié, induite par la génération de ces porteurs de charge, et elle est réalisée sur un appareil WT200 de chez Semilab.

Ces analyses prouvent que le silicium formé avec les creusets des exemples 1 à 4 conformes à l'invention présente des durées de vie, et donc une pureté bien meilleure que le silicium (témoin) formé dans un creuset présentant le revêtement anti-adhérent standard. L'épaisseur de la zone polluée est estimée à environ 20 mm dans le lingot témoin tandis qu'elle est comprise entre 2 et 10 mm dans les lingots moulés dans des creusets revêtus selon l'invention.

### EXEMPLE 6

Le creuset utilisé est un creuset en silice frittée (Zyarock™) de la société Vésuvius, de diamètre interne 150 mm et de hauteur interne 150 mm.

### Préparation du matériau particulaire

Le matériau particulaire est obtenu à partir du broyage d'un massif de polysilazanes (Ceraset PSZ20™ de la société CLARIANT) polymérisés sous argon à 200°C pendant 2 heures puis pyrolysés sous argon pendant une heure à 1000°C, par un broyeur planétaire (PM100 de la société Retsch) dont les éléments sont en agate ultra pure.

La poudre obtenue est constituée de grains amorphes de composition SiNCO. La technique MEB (microscope électronique à balayage) a mis en évidence que moins d'un quart de la population totale présente des dimensions supérieures à 10 µm.

### Formation du revêtement du creuset

Une couche multi-strates selon l'invention ou encore un empilement de tuiles non jointives selon l'invention a été formé sur ce creuset, selon le protocole suivant.

La poudre précédemment formée est dispersée dans une solution (dans un rapport volumique poudre/solution de 50/50) contenant 50 % en poids de polysilazane (Ceraset PSZ20TM de la société CLARIANT) dans du dibutyléther sous agitation vigoureuse.

Une strate est ensuite formée de la façon suivante :
- projection de la suspension obtenue par pulvérisation sur la surface interne du creuset,
- recuit à basse température (150°C pendant 2 heures), et
- pré-pyrolyse à 500°C pendant 30 minutes
- reproduction 4 fois de la succession d'étapes précédentes de telle sorte à obtenir 4 sous-strates dont la pyrolyse sous air pendant 2 heures à 1000°C conduit à la formation de la strate attendue.

Cette succession d'étapes (formation de 4 sous-strates/pyrolyse) est répétée 2 fois afin d'obtenir la couche finale. La couche déposée présente une épaisseur d'environ 100 µm estimée par microscopie optique.

### Formation d'un lingot de silicium dans le creuset disposant du revêtement

Le creuset selon l'invention ainsi formé est testé comme suit :
800 g de silicium solide de qualité électronique sont ensuite placés manuellement et très délicatement dans le creuset résultant, puis fondus selon le cycle suivant : montée en température à une vitesse de 200 °C par heure jusqu'à 1000 °C sous vide primaire, suivi d'un palier d'une durée d'une heure avec introduction d'une atmosphère d'argon circulant (débit 0,7 l/min), puis montée en température à une vitesse de 100 °C par heure jusqu'à 1470 °C et maintien à cette température pendant 5 heures, et enfin descente à une vitesse de 100 °C par heure jusqu'à 1000 °C. Le refroidissement s'effectue ensuite librement jusqu'à température ambiante.

Après refroidissement complet, le lingot de silicium ainsi formé se détache du creuset conforme à l'invention sans efforts et sans présenter aucune fissure.

### Références

[1] Buonassisi et al., "Transition metals in PV-grade ingot-cast multicrystalline silicon: Assessing the role of impurities in Si3N4 crucible lining material", J. Crystal Growth 287 (2006) 402-407.
[2] T. Ohishi, "Gas barrier characteristics of a polysilazane film formed on an ITO-coated PET substrate", J. Non-Crystalline Solids 330 (2003) 248-251.
[3] Kojima et al., "Characteristics of polysilazane compound and its application as coating for carbon material", J. Materials Science Lettes 21 (2002) 757-760.
[4] EP 0 411 611
[5] Bill J. et al., "Polymer-derived ceramic coatings on C/C-SiC composites", J. European Ceramic Society, 16 (1996) 1115-1120.
[6] T.-H. Ho et al., "Modification of epoxy resins with polysiloxane thermoplastic polyurethane for electronic encapsulation", Polymer, 37 (1996) 2733-2742.
[7] C. Vakifahmetoglu et al., "Ceramic foams and micro-beads from emulsions of a preceramic polymer", J. European Ceramic Society 31 (2011) 1481-1490.

## Revendications

1. Creuset utile pour la solidification d'un lingot de silicium à partir de silicium fondu, **caractérisé en ce qu'**il est revêtu au moins partiellement sur sa surface interne d'une couche externe se présentant sous la forme d'un empilement de strates, chaque strate possédant une épaisseur variant de 5 à 150 µm, et étant formée d'un matériau obtenu par décomposition thermique de polysilazane(s) et/ou de polysiloxane(s) et dans lequel sont intégrées des particules inorganiques dont la taille varie de 50 nm à 200 µm.

2. Creuset selon la revendication 1, **caractérisé en ce que** les dimensions desdites particules inorganiques varient de 500 nm à 50 µm et de préférence de 0,8 µm à 10 µm.

3. Creuset selon la revendication 1 ou 2, **caractérisé en ce que** lesdites particules inorganiques sont choisies parmi des particules de silicium, éventuellement oxydées en surface, de nitrure de bore, de nitrure de silicium, de carbure de silicium, d'oxycarbure de silicium, de silice, d'oxycarbonitrure de silicium, de carbonitrure de silicium et de bore, et leurs mélanges, lesdites particules inorganiques étant préférentiellement de même nature chimique que le matériau formant la strate ou les strates les contenant.

4. Creuset selon l'une quelconque des revendications précédentes, **caractérisé en ce que** la couche externe comprend de 2 à 8 strates, en particulier de 4 à 6 strates, lesdites strates étant superposées et contiguës.

5. Creuset selon l'une quelconque des revendications précédentes, **caractérisé en ce que** l'épaisseur d'une strate varie de 10 µm à 50 µm.

6. Creuset selon l'une quelconque des revendications précédentes, **caractérisé en ce que** le matériau obtenu par décomposition thermique de polysilazane(s) et/ou de polysiloxane(s) est à base de carbure de silicium, de nitrure de silicium, de silice, d'oxycarbonitrure de silicium et/ou d'oxycarbure de silicium.

7. Creuset selon l'une quelconque des revendications précédentes, **caractérisé en ce qu'**une ou plusieurs des strates, voire l'ensemble des strates constituant ladite couche, est/sont formée(s) d'un matériau obtenu par décomposition thermique de polysilazane(s), ledit matériau étant en particulier, au moins en partie, sous forme amorphe, dans lequel sont intégrées des particules inorganiques.

8. Creuset selon la revendication précédente, **caractérisé en ce que** lesdites particules inorganiques sont des particules d'oxycarbure de silicium.

9. Creuset selon la revendication 7, **caractérisé en ce que** lesdites particules inorganiques sont des particules formées majoritairement de silice.

10. Creuset selon l'une quelconque des revendications précédentes, **caractérisé en ce que** l'ensemble des strates constituant ladite couche sont formées d'un même matériau.

11. Creuset selon l'une quelconque des revendications 1 à 9, **caractérisé en ce qu'**au moins deux strates de ladite couche sont formées de matériaux différents.

12. Creuset selon l'une quelconque des revendications précédentes, **caractérisé en ce qu'**une ou plusieurs des strates, voire l'ensemble des strates formant la couche externe, se présentent sous la forme de tuiles non jointives, lesdites tuiles d'une strate étant de préférence espacées latéralement de 0,1 à 50 µm, en particulier de 0,1 à 20 µm, plus particulièrement de 0,5 à 10 µm, et de préférence de 0,5 à 5 µm.

13. Creuset selon l'une quelconque des revendications précédentes, **caractérisé en ce que** la couche externe présente une épaisseur allant de 10 à 500 µm, en particulier de 50 à 300 µm, de préférence de 100 à 200 µm.

14. Creuset selon l'une quelconque des revendications précédentes, **caractérisé en ce qu'**il est constitué d'un substrat céramique dense, par exemple en carbure de silicium, en nitrure de silicium ou en silice ou d'un substrat poreux, par exemple en graphite, éventuellement recouvert d'une couche imperméabilisante (en carbure de silicium par exemple).

15. Procédé pour former un revêtement anti-adhérent de haute pureté sur la surface interne d'un creuset utile pour la solidification d'un lingot de silicium à partir de silicium fondu, **caractérisé en ce que** ledit revêtement est obtenu *via*
▪ (a) la formation d'au moins une strate selon un traitement comprenant :
(1) au moins une fois l'enchaînement des étapes :
(i) mise en contact de la surface interne dudit creuset, avec une solution comprenant au moins un polysilazane et/ou un polysiloxane, et contenant en outre un matériau particulaire dont les particules possèdent une taille variant de 50 nm à 200 µm, dans des proportions materiau particulaire/polysilazane et/ou polysiloxane allant de 10 à 70 % en volume, de préférence de 40 à 50 % en volume ;
(ii) condensation-réticulation de ladite solution par traitement thermique ; et
(iii) éventuellement une pré-pyrolyse sous air à une température allant de 270 à 700°C ;
(2) une pyrolyse sous atmosphère et température contrôlées à une température supérieure à 700°C pendant au moins 1 heure et, éventuellement ;
(3) un recuit d'oxydation ; suivie de
▪ (b) la superposition d'une ou plusieurs strates consécutives sur la strate formée en étape (a), chaque strate étant formée par répétition au moins une fois de l'enchaînement des étapes (i), (ii) et éventuellement (iii), suivie de l'étape (2) et éventuellement de l'étape (3).

16. Procédé selon la revendication précédente, **caractérisé en ce que** la formation d'au moins une desdites strates comprend l'étape (iii) de pré-pyrolyse, cette étape étant de préférence réalisée à une température allant de 400 à 600°C.

17. Procédé selon la revendication 16, **caractérisé en ce que** la formation d'au moins une strate impliquant la mise en oeuvre des étapes (i), (ii) et (iii), comprend préalablement à la mise en oeuvre de l'étape (2), la répétition au moins une fois, des étapes (i), (ii) et (iii).

18. Procédé selon l'une quelconque des revendications 15 à 17, **caractérisé en ce que** l'étape de pyrolyse (2) de l'une des étapes (a) et (b) est réalisée sous atmosphère réactive à l'égard du matériau dérivant du polysilazane et/ou du polysiloxane, par exemple sous azote ou sous air, l'autre étape étant réalisée sous atmosphère inerte, par exemple sous argon.

19. Procédé selon l'une quelconque des revendications 15 à 18, **caractérisé en ce que** la solution comprenant au moins un polysilazane et/ou un polysiloxane comprend également un solvant, en particulier un solvant anhydre aprotique, en particulier choisi parmi le toluène, le diméthylformamide, le diméthylsulfoxyde et le dibutyléther ; et, le cas échéant, un initiateur de polymérisation, par exemple de type peroxyde organique.

20. Procédé selon l'une quelconque des revendications 15 à 19, **caractérisé en ce que** ladite solution de polysilazane et/ou polysiloxane comprend de 10 à 90 % en poids de polysilazane(s) et/ou polysiloxane(s), par rapport à son poids total, en particulier de 20 à 80 % en poids, et plus particulièrement de 40 à 60 % en poids.

## Patentansprüche

1. Tiegel für die Verfestigung von geschmolzenem Silizium zu einem Siliziumblock, **dadurch gekennzeichnet, dass** er auf seiner inneren Oberfläche zumindest zum Teil mit einer äußeren Schicht ausgekleidet ist, die die Form eines Stapels aus mehreren Lagen hat, wobei jede Lage eine Dicke zwischen 5 und 150 µm hat, aus einem Material gebildet ist, das erhalten wird durch thermische Zersetzung von Polysilazan(en) und/oder Polysiloxan(en) und in die anorganische Partikel integriert sind, deren Größe zwischen 50 nm und 200 µm variiert.

2. Tiegel nach Anspruch 1, **dadurch gekennzeichnet, dass** die Abmessungen der genannten anorganischen Partikel zwischen 500 nm und 50 µm, vorzugsweise zwischen 0,8 µm und 10 µm variieren.

3. Tiegel nach Anspruch 1 oder 2, **dadurch gekennzeichnet, dass** die genannten anorganischen Partikel ausgewählt sind unter Partikeln aus Silizium, ggf. an der Oberfläche oxidiert, Bornitrid, Siliziumnitrid, Siliziumkarbid, Siliziumoxicarbid, Silizium , Siliziumoxicarbonitrid, Silizium/Borcarbonitrid und Mischungen hieraus, wobei die genannten anorganischen Partikel vorzugsweise die gleiche chemische Beschaffenheit aufweisen wie das Material, das die Lage oder Lagen bildet, in denen sie enthalten sind.

4. Tiegel nach einem der vorstehenden Ansprüche, **dadurch gekennzeichnet, dass** die äußere Schicht zwei bis acht Lagen aufweist, insbesondere vier bis sechs Lagen, wobei diese Lagen einander überlagert und durchgehend sind.

5. Tiegel nach einem der vorstehenden Ansprüche, **dadurch gekennzeichnet, dass** die Dicke einer Lage zwischen 10 µm und 50 µm beträgt.

6. Tiegel nach einem der vorstehenden Ansprüche, **dadurch gekennzeichnet, dass** das durch thermische Zersetzung von Polysilazan(en) und/oder von Polysiloxan(en) erhaltene Material ein Material auf der Basis von Siliziumkarbid, Siliziumnitrid, Silizium , Siliziumoxidcarbonitrid und/oder Siliziumoxikarbid ist.

7. Tiegel nach einem der vorstehenden Ansprüche, **dadurch gekennzeichnet, dass** eine oder mehrere der Lagen oder die Gesamtheit der Lagen, die die genannte Schicht bilden, aus einem Material gebildet sind, das erhalten wird durch thermische Zersetzung von Polysilazan(en), wobei dieses Material insbesondere, zumindest zum Teil, in amorpher Form vorliegt, und in das anorganische Partikel integriert sind.

8. Tiegel nach dem vorstehenden Anspruch, **dadurch gekennzeichnet, dass** die anorganischen Partikel Partikel aus Siliziumoxikarbid sind.

9. Tiegel nach Anspruch 7, **dadurch gekennzeichnet, dass** die genannten anorganischen Partikel Partikel sind, die vorwiegend aus Silizium gebildet sind.

10. Tiegel nach einem der vorstehenden Ansprüche, **dadurch gekennzeichnet, dass** die Gesamtheit der Lagen, die die genannte Schicht bilden, aus einem gleichen Material gebildet sind.

11. Tiegel nach einem der Ansprüche 1 bis 9, **dadurch gekennzeichnet, dass** wenigstens zwei Lagen der genannten Schicht aus verschiedenen Materialien gebildet sind.

12. Tiegel nach einem der vorstehenden Ansprüche, **dadurch gekennzeichnet, dass** eine oder mehrere der Lagen oder die Gesamtheit der Lagen, die die äußere Schicht bilden, in der Form von nicht fugendichten Ziegeln vorliegen, wobei die genannten Ziegel einer Lage vorzugsweise seitliche Abstände von 0,1 bis 50 µm, insbesondere 0,1 bis 20 µm, weiterhin insbesondere 0,5 bis 10 µm, vorzugsweise 0,5 bis 5 µm zueinander aufweisen.

13. Tiegel nach einem der vorstehenden Ansprüche, **dadurch gekennzeichnet, dass** die äußere Schicht eine Dicke von 10 bis 500 µm hat, insbesondere von 50 bis 300 µm, vorzugsweise von 100 bis 200 µm.

14. Tiegel nach einem der vorstehenden Ansprüche, **dadurch gekennzeichnet, dass** er durch ein dichtes keramisches Substrat gebildet wird, beispielsweise Siliziumkarbid, Siliziumnitrid oder Siliziumdioxid, oder aus einem porösen Substrat, beispielsweise Graphit, ggf. bedeckt mit einer die Durchlässigkeit verhindernden Schicht (beispielsweise aus Siliziumkarbid).

15. Verfahren zur Herstellung einer Antihaftbeschichtung von hoher Reinheit auf der inneren Oberfläche eines Tiegels für die Verfestigung von geschmolzenem Silizium zu einem Siliziumblock, **dadurch gekennzeichnet, dass** die genannte Auskleidung erhalten wird durch
(a) die Bildung wenigstens einer Lage durch eine Behandlung, die umfasst:
(1) wenigstens einmalige Verkettung der Schritte:
(i) in Kontakt bringen der inneren Oberfläche des genannten Tiegels mit einer Lösung, die wenigstens eine Polysilazan und/oder ein Polysiloxan enthält und außerdem ein partikelförmiges Material enthält, dessen Partikel eine Größe von 50 nm bis 200 µm aufweisen, in Materialverhältnissen von Partikel zu Polysilazan und/oder Polysiloxan zwischen 10 und 70 Vol%, vorzugsweise 40 und 50 Vol.%,
(ii) Kondensations-Vernetzung der genannten Lösung durch thermische Behandlung; und
(iii) ggf. einer Prä-Pyrolyse unter Luft bei einer Temperatur von 270 bis 700°C;
(2) eine Pyrolyse unter einer Atmosphäre und Temperatur die kontrolliert ist auf eine Temperatur von mehr als 700°C für wenigstens eine Stunde und, ggf.;
(3) Brennen zur Oxidation; gefolgt von
(b) die Überlagerung einer oder mehrerer aufeinanderfolgender Lagen auf der in Schritt (a) gebildeten Lage, wobei jede Lage durch wenigstens einmalige Wiederholung der Verkettung der Schritte (i), (ii) und ggf. (iii) gebildet wird, gefolgt von dem Schritt (2) und ggf. dem Schritt (3).

16. Verfahren nach dem vorstehenden Anspruch, **dadurch gekennzeichnet, dass** die Bildung wenigstens einer der genannten Lagen den Schritt (iii) der Prä-Pyrolyse enthält, wobei dieser Schritt vorzugsweise bei einer Temperatur von 400 bis 600°C ausgeführt wird.

17. Verfahren nach Anspruch 16, **dadurch gekennzeichnet, dass** die Bildung wenigstens einer Lage, die die Ausführung der Schritte (i), (ii) und (iii) einschließt, die vorherige Ausführung des Schrittes (2) und das mindestens einmalige Wiederholen der Schritte (i), (ii) und (iii) einschließt.

18. Verfahren nach einem der Ansprüche 15 bis 17, **dadurch gekennzeichnet, dass** der Schritt (2) der Pyrolyse in einem der Schritte (a) und (b) unter einer Atmosphäre ausgeführt wird, die im Hinblick auf das aus Polysilazan und/oder Polysiloxan abgeleitete Material reaktiv ist, beispielsweise unter Stickstoff oder Luft, wobei der andere Schritt unter einer inerten Atmosphäre ausgeführt wird, beispielsweise unter Argon.

19. Verfahren nach einem Ansprüche 15 bis 18, **dadurch gekennzeichnet, dass** die Lösung, die wenigstens ein Polysilazan und/oder ein Polysiloxan enthält, außerdem ein Lösungsmittel enthält, insbesondere ein wasserfreies aprotisches Lösungsmittel, insbesondere ausgewählt unter Toluol, Dimetheyformamid, Dimethylsulfoxid und Dibutylether, und ggf. einen Polymerisationsinitiator, beispielsweise von der Art eines organischen Peroxids.

20. Verfahren nach einem der Ansprüche 15 bis 19, **dadurch gekennzeichnet, dass** die genannte Lösung aus Polysilazan und/oder Polysiloxan bezogen auf ihr Gesamtgewicht 10 bis 90 Gew.% Polysilaxan(e) und/oder Polysiloxan(e) enthält, insbesondere 20 bis 80 Gew.% und weiter insbesondere 40 bis 60 Gew.%.

## Claims

1. A crucible useful for solidifying a silicon ingot from molten silicon, **characterized in that** it is coated at least partially on its inner surface with an outer layer that is in the form of a stack of strata, each stratum having a thickness varying from 5 to 150 µm, and being formed from a material obtained by thermal decomposition of polysilazane(s) and/or polysiloxane(s) and in which inorganic particles having a size that varies from 50 nm to 200 µm are incorporated.

2. The crucible as claimed in claim 1, **characterized in that** the dimensions of said inorganic particles vary from 500 nm to 50 µm and preferably from 0.8 µm to 10 µm.

3. The crucible as claimed in claim 1 or 2, **characterized in that** said inorganic particles are selected from silicon particles that are optionally surface oxidized, boron nitride particles, silicon nitride particles, silicon carbide particles, silicon oxycarbide particles, silica particles, silicon oxycarbonitride particles, silicon and boron carbonitride particles, and mixtures thereof, said inorganic particles are preferably of the same chemical nature as the material forming the stratum or the strata containing them.

4. The crucible as claimed in any one of the preceding claims, **characterized in that** the outer layer comprises from 2 to 8 strata, in particular from 4 to 6 strata, said strata being superposed and contiguous.

5. The crucible as claimed in any one of the preceding claims, **characterized in that** the thickness of a stratum varies from 10 µm to 50 µm.

6. The crucible as claimed in any one of the preceding claims, **characterized in that** the material obtained by thermal decomposition of polysilazane(s) and/or polysiloxane(s) is based on silicon carbide, silicon nitride, silica, silicon oxycarbonitride and/or silicon oxycarbide.

7. The crucible as claimed in any one of the preceding claims, **characterized in that** one or more of the strata, or even all of the strata constituting said layer, is/are formed from a material obtained by thermal decomposition of polysilazane(s), said material being in particular, at least partly, in amorphous form, in which inorganic particles are incorporated.

8. The crucible as claimed in the preceding claim, **characterized in that** said inorganic particles are silicon oxycarbide particles.

9. The crucible as claimed in claim 7, **characterized in that** said inorganic particles are particles formed predominantly from silica.

10. The crucible as claimed in any one of the preceding claims, **characterized in that** all of the strata constituting said layer are formed from one and the same material.

11. The crucible as claimed in any one of claims 1 to 9, **characterized in that** at least two strata of said layer are formed from different materials.

12. The crucible as claimed in any one of the preceding claims, **characterized in that** one or more of the strata, or even all of the strata forming the outer layer, are in the form of non-touching tiles said tiles of one stratum are preferably spaced out laterally by 0.1 µm to 50 µm, in particular by 0.1 µm to 20 µm, more particularly by 0.5 µm to 10 µm, and preferably by 0.5 µm to 5 µm.

13. The crucible as claimed in any one of the preceding claims, **characterized in that** the outer layer has a thickness ranging from 10 µm to 500 µm, in particular from 50 µm to 300 µm, preferably from 100 µm to 200 µm.

14. The crucible as claimed in any one of the preceding claims, **characterized in that** it consists of a dense ceramic substrate, for example made of silicon carbide, silicon nitride or silica, or of a porous substrate, for example made of graphite, optionally covered with an impermeabilizing layer (for example made of silicon carbide).

15. A process for forming a high-purity non-stick coating on the inner surface of a crucible useful for solidifying a silicon ingot from molten silicon, **characterized in that** said coating is obtained *via*
▪ (a) the formation of at least one stratum according to a treatment comprising:
(1) at least once the sequence of the steps:
(i) bringing the inner surface of said crucible into contact with a solution comprising at least one polysilazane and/or one polysiloxane, and additionally containing a particulate material, the particles of which have a size varying from 50 nm to 200 µm, in particulate material/ polysilazane and/or polysiloxane proportions ranging from 10% to 70% by volume, preferably from 40% to 50% by volume;
(ii) condensation-crosslinking of said solution by heat treatment; and
(iii) optionally a pre-pyrolysis in air at a temperature ranging from 270°C to 700°C;
(2) a pyrolysis under controlled atmosphere and controlled temperature, at a temperature above 700°C for at least 1 hour and, optionally;
(3) an oxidation annealing; followed by
▪ (b) the superposing of one or more consecutive strata on the stratum formed in step (a), each stratum being formed by repeating at least once the sequence of steps (i), (ii) and optionally (iii), followed by step (2) and optionally step (3).

16. The process as claimed in the preceding claim, **characterized in that** the formation of at least one of said strata comprises the pre-pyrolysis step (iii), said pre-pyrolysis step (iii) is carried out at a temperature ranging from 400°C to 600°C..

17. The process as claimed in claim 16, **characterized in that** the formation of at least one stratum involving the implementation of steps (i), (ii) and (iii) comprises, prior to the implementation of step (2), the repetition, at least once, of steps (i), (ii) and (iii).

18. The process as claimed in any one of claims 15 to 17, **characterized in that** the pyrolysis step (2) of one of steps (a) and (b) is carried out under a reactive atmosphere, which is reactive with respect to the material that is derived from the polysilazane and/or polysiloxane, for example under nitrogen or air, the other step being carried out under an inert atmosphere, for example under argon.

19. The process as claimed in any one of claims 15 to 18, **characterized in that** the solution comprising at least one polysilazane and/or one polysiloxane also comprises a solvent, in particular an aprotic anhydrous solvent, in particular selected from toluene, dimethylformamide, dimethyl sulfoxide and dibutyl ether and, where appropriate, a polymerization initiator, for example of organic peroxide type.

20. The process as claimed in any one of claims 15 to 19, **characterized in that** said solution of polysilazane and/or polysiloxane comprises from 10% to 90% by weight of polysilazane(s) and/or polysiloxane(s), with respect to its total weight, in particular from 20% to 80% by weight, and more particularly from 40% to 60% by weight.
